# FASCICULE DE BREVET EUROPEEN

(11) **EP 3 192 106 B1**
(45) Date de publication et mention de la délivrance du brevet: **24.10.2018**
(21) Numéro de dépôt: 15762594.8
(22) Date de dépôt: 09.09.2015
(51) Int. Cl.: H01L 43/00, H01F 10/32, G11C 11/16, G11C 11/18, B82Y 25/00

(54) **SYSTÈME DE GÉNÉRATION DE SKYRMIONS**
SYSTEM ZUR SKYRMION-ERZEUGUNG
SKYRMION GENERATION SYSTEM

(30) Priorité: 09.09.2014 FR 1402021
(43) Date de publication de la demande: 19.07.2017
(73) Titulaire: Thales, 92400 Courbevoie (FR); Centre National de la Recherche Scientifique, 75016 Paris (FR)
(72) Inventeur: CROS, Vincent, F-91767 Palaiseau (FR); VAN HORNE, Noah, F-91767 Palaiseau (FR); SAMPAIO, Joao, F-91767 Palaiseau (FR); FERT, Albert, F-91767 Palaiseau (FR); REYREN, Nicolas, F-91767 Palaiseau (FR)
(74) Mandataire: Lavoix
(86) Numéro de dépôt international: PCT/EP2015/070657
(87) Numéro de publication internationale: WO 2016/038113

(56) Documents cités:
- JP-A- 2014 086 470
- JUNICHI ET AL: "Current-induced skyrmion dynamics in constricted geometries", NATURE NANOTECHNOLOGY, vol. 8, no. 10, 8 septembre 2013 (2013-09-08), pages 742-747, XP055119148, ISSN: 1748-3387, DOI: 10.1038/nnano.2013.176
- YOUNGBIN ET AL: "Skyrmion generation by current", PHYSICAL REVIEW B, vol. 85, no. 17, 1 mai 2012 (2012-05-01), XP055119150, ISSN: 1098-0121, DOI: 10.1103/PhysRevB.85.174416

## Description

La présente invention concerne un système de génération de skyrmions magnétiques.

Les skyrmions magnétiques sont utilisés dans le domaine de la spintronique. Pour rappel, le domaine spintronique, encore appelé domaine à électronique de spin, est un domaine de l'électronique utilisant le spin de l'électron et non pas seulement la charge, pour le traitement de l'information.

De tels systèmes à mémoire magnétiques sont par exemple des systèmes de stockage de masse, des registres à décalage, des systèmes logiques et mémoires analogiques par exemple pour des circuits de type neuro-inspirés.

Tous ces systèmes de mémoire à élément(s) spintronique(s), qui ont l'avantage d'être non volatiles, compatibles avec la technologie CMOS (ou Complementary Metal Oxide Semiconductor, est une technologie de fabrication de composants électroniques et, par extension, l'ensemble des composants fabriqués selon cette technologie) et résistant aux radiations électromagnétiques, sont basés sur un élément spintronique appelé Jonction Tunnel Magnétique (MTJ) qui est un empilement principalement constitué de deux couches magnétiques minces (quelques nanomètres) séparées par une couche isolante (de l'ordre du nanomètre) ou bien par une vanne de spin (spin valve en anglais notée SV) dans laquelle l'ensemble des couches sont métalliques.

Pour un élément spintronique de type mémoire binaire, le bit de la mémoire correspond à une MTJ (respectivement une SV) de quelques dizaines à quelques centaines de nanomètres de côté dont l'état, alternativement 0 et 1, est obtenu par deux configurations possibles de la direction relative des aimantations dans les deux couches magnétiques (Parallèle ou Antiparallèle). La lecture de l'état de la mémoire se fait par la mesure de la tension aux bornes de la MTJ grâce à l'effet de magnétorésistance à effet tunnel, encore nommée TMR. L'écriture de l'état est effectuée, dans les dernières générations d'élément (appelé STT-MRAM), par effet de transfert de spin (Spin Transfer Torque en anglais, noté STT) qui permet d'agir sur la direction d'une (ou des) aimantation(s) et donc de modifier leur configuration par injection d'un courant polarisé en spin, en passant de Parallèle à Antiparallèle ou vice versa, sans nécessité d'appliquer un champ magnétique.

Dans les systèmes plus complexes tels que les systèmes de registre à décalage ou les memristors spintroniques, les modifications d'état sont basées sur le déplacement contrôlé de parois de domaines magnétiques. De la même façon que pour les éléments spintronique à mémoire binaire, la lecture est effectuée par effet magnétorésistif et l'écriture est réalisée par effet de transfert de spin, qui dans ces éléments spintroniques à mémoire binaire permet de déplacer les parois de domaine.

Plusieurs problèmes techniques restent à résoudre dans les technologies existantes de systèmes de mémoire à élément(s) spintronique. Premièrement, il convient de réduire la consommation énergétique associée à l'écriture de l'information. En effet, le coût en énergie a augmenté avec la diminution des dimensions des composants. Cette augmentation est liée à l'impératif de préserver ou même d'augmenter l'efficacité des effets de transfert de spin qui sont utilisés pour écrire l'information (par renversement de la direction de l'aimantation) et à l'influence accrue des défauts naturels ou liés à la nano-fabrication qui imposent d'injecter des densités de courant de plus en plus importantes pour atteindre les régimes d'écriture non stochastique.

Il est également souhaitable, tout en réduisant la consommation électrique (utilisée pour les différentes fonctions de la mémoire), de préserver une intensité de signal mesurée suffisante pour une bonne détection de l'état de la mémoire.

Deuxièmement, il convient d'augmenter la densité d'information pouvant être stockée dans les mémoires spintroniques non volatiles, ce qui pourrait se faire soit en augmentant le niveau d'intégration (i.e diminution de la taille du bit individuel) soit en allant au-delà des architectures de mémoires standards qui sont binaires.

Une solution consiste à disposer de mémoires à multi-états, dits encore à multi-niveaux. Cependant, dans les mémoires magnétiques existantes, la commutation entre deux directions différentes des aimantations uniformes ne permet de coder qu'un seul bit par élément de mémoire. L'existence de mémoires à multi-états permettrait d'augmenter fortement la densité de stockage et d'en réduire le coût.

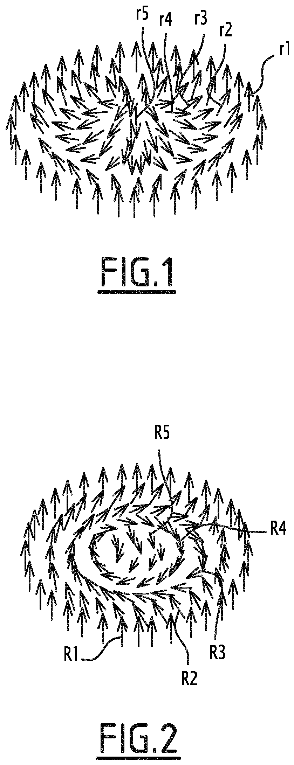

Pour cela, il est souhaitable d'utiliser des skyrmions magnétiques. Les skyrmions magnétiques sont des structures chirales de spin (c'est-à-dire asymétrique par rapport à une inversion de type miroir) présentant une topologie non-triviale et dont la taille peut être extrêmement petite (jusqu'à quelques mailles atomiques) et le sens de rotation entre les spins est imposé. La configuration de ces structures de spin peut être de type « hérisson » (cf. figure 1 où les flèches signalent l'orientation des spins organisés en cercles concentriques r1, r2, r3, r4 et r5)) ou « vortex » (cf. figure 2 où les flèches signalent l'orientation des spins organisés en cercles concentriques R1, R2, R3, R4 et R5).

Un générateur des skyrmions est décrit par JUNICHI ET AL: "Current-induced skyrmion dynamics in constricted geometries", NATURE NANOTECHNOLOGY, vol. 8, no. 10,2013-09-08, pages 742-747. De telles structures magnétiques chirales ont été prédites et observées dans des cristaux tels que MnSi, FeCoSi ou encore FeGe ayant une structure cristalline présentant une brisure de symétrie d'inversion qui permet la manifestation d'une interaction magnétique appelée Dzyaloshinskii-Moriya (DM) et caractérisée par un paramètre nommé D, donnant lieu à la stabilisation des configurations magnétiques de type skyrmion. Dans les systèmes de films minces magnétiques, la brisure de symétrie d'inversion permettant la stabilisation d'une structure magnétique chirale est induite par la présence d'une interface entre un film mince magnétique et un film mince à fort couplage spin orbite (encore appelé SOC ou interaction spin-orbite), ce qui génère une forte interaction DM, donnant lieu à la stabilisation des configurations magnétiques de type skyrmion.

On rappelle que le SOC décrit les interactions entre le spin d'une particule (l'électron dans notre cas) et son mouvement, et revêt une importance particulière en magnétisme, et particulièrement en spintronique, pour expliquer un certain nombre de propriétés fondamentales des matériaux telles que par exemple les anisotropies magnétiques, les effets magnétorésistifs ou encore les processus de relaxation d'aimantation.

On notera que les skyrmions sont protégés topologiquement et donc relativement stables aux variations des paramètres extérieurs ; ils ne peuvent pas être transformés (une fois stabilisés) pour transiter vers un autre ordre magnétique (quasi-uniforme ou vortex par exemple). Comme indiqué précédemment, les skyrmions magnétiques ont été observés seulement en 2009 dans des systèmes de type monocristaux (MnSi, FeCoSi, FeGe...) présentant une absence de symétrie d'inversion liée à la structure cristalline. Ces systèmes dit massifs ne peuvent pas être réduits fortement en épaisseur (de l'ordre de quelques dizaines de nanomètres), ne sont pas compatibles avec les technologies CMOS et surtout ne présentent la phase comportant des réseaux ultra-denses de skyrmions qu'à basse température et sous champ magnétique.

En plus de l'interaction spin orbite, d'autres types d'interaction magnétique, par exemple les interactions dipolaires, peuvent permettre de stabiliser des configurations magnétiques de type skyrmion dans des nanostructures, qui sont alors appelées bulles magnétiques qui peuvent avoir dans le cas de systèmes de films minces magnétiques une structure de spin en hérisson, telle que présentée sur la figure 1. Dans le présent document, notamment dans la description et les revendications ci-après, nous regroupons sous la dénomination générale de skyrmion magnétique les structures de spin schématisées sur les figures 1 et 2.

Ainsi, il est souhaitable de pouvoir générer de manière contrôlée et efficace des skyrmions.

Toutefois, cela n'est pas suffisant puisque, pour le bon fonctionnement des systèmes à base de skyrmions, il convient de pouvoir contrôler le nombre topologique et la chiralité des skyrmions car ces paramètres déterminent directement un ensemble de propriétés des skyrmions, par exemple leur sens de déplacement sous courant mais aussi leur réponse à des excitations radiofréquences externes.

Il existe donc un besoin pour un système de génération de skyrmions permettant la génération de skyrmions avec une topologie et une chiralité déterminée.

Pour cela, il est proposé un système de génération de skyrmions comprenant un canon comportant une région formant paroi réalisée en un premier matériau, la région délimitant un espace extérieur réalisé dans un deuxième matériau distinct du premier matériau et un espace intérieur réalisé dans un troisième matériau distinct du premier matériau, le deuxième matériau et le troisième matériau étant des matériaux magnétiques, la région comportant une paroi de fond et une paroi latérale en liaison avec la paroi du fond au niveau d'une zone de jonction. Le canon comporte aussi une zone de création de demi-bulles propre à générer des demi-bulles, la zone de création étant dans l'espace intérieur. La zone de création comprend au moins l'un des deux éléments suivants : un ou plusieurs défauts de la paroi et une partie de la zone de jonction. Le canon comporte également une zone de traitement des demi-bulles comprenant une sortie en communication avec l'espace extérieur, la sortie étant propre à transformer les demi-bulles en skyrmions, et un passage de propagation des demi-bulles, le passage reliant la zone de création à la sortie. La zone de traitement est propre à limiter le contact entre la zone de création et la sortie étant également propre à transformer les demi-bulles en skyrmions. Le système comporte aussi un dispositif de renversement de l'aimantation magnétique propre à renverser l'aimantation magnétique à l'interface entre la région et l'espace intérieur. Le dispositif de renversement étant choisi dans le groupe constitué d'une première unité d'injection de courant dans une première direction transverse, la première unité étant propre à injecter à la zone de création de demi-bulles un courant polarisé en spin avec une direction de polarisation en spin ayant une composante non nulle le long d'une deuxième direction transverse, la première direction transverse et la deuxième direction transverse étant perpendiculaires à une direction longitudinale le long de laquelle s'étend le canon, d'une première unité d'injection de courant dans une première direction transverse, la première unité étant propre à injecter à la zone de création de demi-bulles un courant polarisé en spin avec une direction de polarisation en spin ayant une composante non nulle le long d'une direction longitudinale le long de laquelle s'étend le canon, la première direction transverse étant perpendiculaire à la direction longitudinale, d'une unité d'application d'un champ magnétique extérieur à la zone de création de demi-bulles, d'une unité de chauffage de la zone de création de demi-bulles et d'une unité d'application d'un champ électrique extérieur à la zone de création de demi-bulles.

Suivant des modes de réalisation particuliers, le système de génération comprend une ou plusieurs des caractéristiques suivantes, prise(s) isolément ou suivant toute combinaison techniquement possible :
- la partie de la zone de jonction est une partie dans laquelle l'angle entre la paroi de fond et la paroi latérale est inférieur ou égal à 180°.
- au moins l'un du deuxième matériau magnétique et du troisième matériau magnétique est choisi dans le groupe constitué d'une couche ferromagnétique interfacée avec une couche non magnétique, la couche ferromagnétique comprenant au moins un matériau parmi Fe, Co ou Ni, un pérovskite ferromagnétique simple ou double base à base de Ti, Cr, Mn, Fe, Co, Mo ou Ru, un alliage Heusler à base de Fe, Co, Ni ou Mn, un semi-conducteur magnétique ou un alliage magnétique contenant un élément Terres Rares (Sm, Gd, Tb ou Er par exemple), d'une couche non magnétique comprenant au moins un matériau parmi les éléments Pt, W, Ir, Re, Ta, Pb, Bi, Rh, Pd, Mo, Cu, Sm, Gd, Tb ou Er, ladite couche non magnétique étant interfacée avec un couche ferromagnétique ou un empilement de couches ferromagnétique(s) et/ou non magnétique(s), et d'un matériau magnétique présentant une absence de symétrie d'inversion.
- le dispositif de renversement de l'aimantation magnétique est la première unité d'injection de courant, le système comportant, en outre, une deuxième unité d'injection de courant dans la première direction transverse, la deuxième unité d'injection de courant étant propre à injecter dans le passage de propagation un courant polarisé en spin avec une direction de polarisation en spin différente de la direction de polarisation en spin du courant que la première unité est propre à injecter.
- le passage de propagation comporte deux portions reliées par un coude.
- le système est propre à générer des skyrmions présentant une extension, la sortie présentant une forme géométrique dont au moins une dimension est supérieure à l'extension d'un skyrmion que le système est propre à générer.
- le système est propre à générer des skyrmions présentant une extension, le passage de propagation présentant une largueur supérieure ou égale à la moitié de l'extension d'un skyrmion que le système est propre à générer.
- le système est propre à générer des skyrmions présentant une extension, le passage de propagation présentant une longueur supérieure ou égale à l'extension d'un skyrmion que le système est propre à générer.
- le troisième matériau présente une troisième longueur d'échange, la largeur de la paroi latérale étant supérieure ou égale si le premier matériau est un matériau magnétique présentant une première longueur d'échange, à la première longueur d'échange, si le premier matériau est un matériau conducteur magnétique, à la longueur de diffusion de spin, et si le premier matériau est isolant ou du vide, à la longueur caractéristique d'effet tunnel.
- le troisième matériau présente une troisième longueur d'échange, la zone de création étant inscriptible dans un cercle ayant un rayon inférieur ou égal à la troisième longueur d'échange.

D'autres caractéristiques et avantages de l'invention apparaîtront à la lecture de la description qui suit de modes de réalisation de l'invention, donnée à titre d'exemple uniquement et en référence aux dessins qui sont :
- figure 1, une vue d'un type de structure de skyrmion,
- figure 2, une vue d'un autre type de structure de skyrmion,
- figure 3, une représentation schématique d'une vue de haut d'un exemple de système de génération de skyrmions,
- figure 4, une représentation schématique d'une vue de haut d'un exemple de système de génération de skyrmions en fonctionnement,
- figure 5, une représentation schématique d'une vue de haut d'un exemple de système de génération de skyrmions en fonctionnement,
- figure 6, une représentation schématique d'une vue de haut d'un exemple de système de génération de skyrmions mettant en évidence les dimensions caractéristiques,
- figure 7, une représentation schématique d'une vue de côté d'un exemple de système de génération de skyrmions,
- figure 8, une représentation schématique d'une vue de côté d'un autre exemple de système de génération de skyrmions,
- figure 9, une représentation schématique d'une vue de côté d'un autre exemple de système de génération de skyrmions,
- figure 10, une représentation schématique d'une vue de haut d'un autre exemple de système de génération de skyrmions,
- figure 11 une représentation schématique d'une vue de haut d'un autre exemple de système de génération de skyrmions,
- figure 12, une représentation schématique d'une vue de haut d'un autre exemple de système de génération de skyrmions,
- figure 13, une représentation schématique d'une vue de haut d'un autre exemple de système de génération de skyrmions,
- figure 14, une représentation schématique d'une vue de haut d'un autre exemple de système de génération de skyrmions, et
- figure 15, une représentation schématique d'une vue de haut d'un autre exemple de système de génération de skyrmions

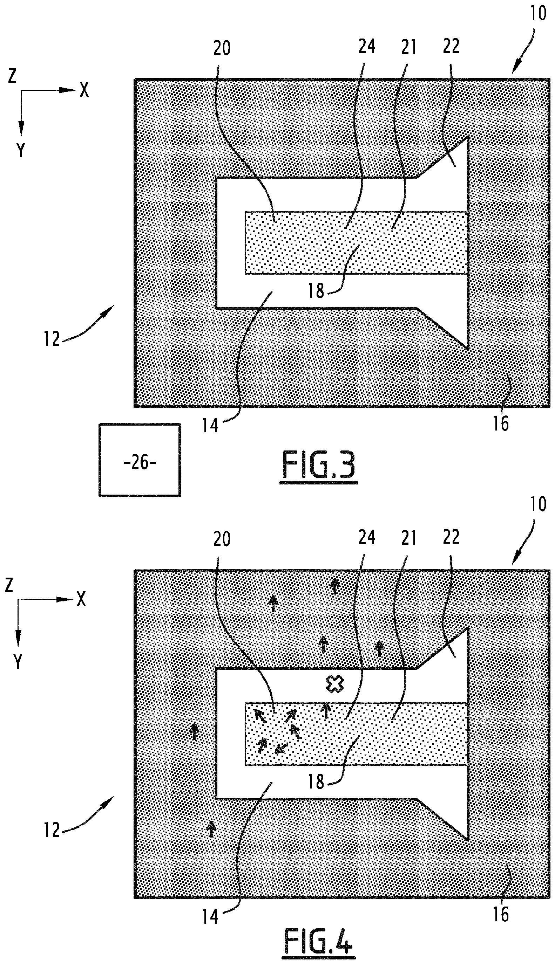

Il est proposé, en référence à la figure 3, un système de génération 10 de skyrmions.

Le système de génération 10 est un système propre à générer des skyrmions.

Les skyrmions que le système de génération 10 est propre à générer présentent une extension notée R dans la suite.

Plus précisément, dans le cadre de la description, l'extension R d'un skyrmion est la taille d'un skyrmion relaxée telle que cette extension est définie par l'équation 18 dans l'article S. Rohart et al. Phys. Rev. B 88, 184422 (2013) en fonction du paramètre D, entre autres.

L'extension R est mesurable par des techniques d'imagerie magnétique ou magnéto-optique. Le paramètre D entrant dans la définition de l'extension R peut être obtenu à partir de la mesure des vitesses de déplacements de parois sous champ ou sous courant par exemple.

L'extension des skyrmions individuels, c'est-à-dire en nombre fini, dans des réseaux non-denses, est déterminée par la compétition entre les différents termes d'énergies de la nanostructure (liés à l'interaction d'échange et les interactions DM) et peut atteindre des dimensions ultimes pour un objet magnétique de quelques mailles atomiques (cf. Heinze, S. et al. Nature Phys. 7, 713-718 (2011)).

Le système de génération 10 comporte un canon 12.

Le canon 12 est un élément allongé s'étendant principalement le long d'une direction longitudinale. Deux directions transverses perpendiculaires à la direction longitudinale sont également définies, la première direction transverse étant aussi perpendiculaire à la deuxième direction transverse. La direction longitudinale et les deux directions transverses sont respectivement symbolisées par un axe X et deux axes Z et Y sur la figure 3.

Le canon 12 comporte une région formant paroi 14 réalisée en un premier matériau M1, la région 14 délimitant un espace extérieur 16 réalisé dans un deuxième matériau M2 et un espace intérieur 18 réalisé dans un troisième matériau M3. Le canon 12 comporte également une zone de création 20 de demi-bulles, une zone de traitement 21 comportant une sortie 22 et un passage de propagation 24 reliant la zone de création 20 à la sortie 22.

Une demi-bulle est un domaine magnétique dont la direction de l'aimantation est inversée par rapport à la direction d'aimantation dans le reste de l'espace intérieur 18 et qui est en contact avec la région 14.

Le premier matériau M1 est distinct du deuxième matériau M2. Le premier matériau M1 est également distinct du troisième M3.

Par exemple, selon un mode de réalisation, le premier matériau M1 est un matériau non-magnétique.

Selon un autre mode de réalisation, le premier matériau M1 est le milieu ambiant, la région 14 étant notamment obtenue par une découpe pratiquée dans une couche formant l'espace extérieur 16.

Selon un autre mode de réalisation, les trois matériaux M1, M2 et M3 sont des matériaux magnétiques. Le premier matériau M1 présente des propriétés très différentes du deuxième matériau M2 et du troisième matériau M3.

Dans un tel cas, cela signifie que les paramètres magnétiques du premier matériau M1 sont différents des paramètres magnétiques du deuxième matériau M2, qui eux-mêmes peuvent être différents ou non des paramètres magnétiques du troisième matériau M3. L'anisotropie magnétique, l'épaisseur du matériau ou la présence d'une brisure de symétrie d'inversion sont des exemples de paramètres aisément modifiables.

Selon un mode de réalisation, la paroi 14 est fabriquée par gravure sur un matériau magnétique.

Selon un autre mode de réalisation, la paroi 14 est obtenue en rendant un matériau magnétique non magnétique.

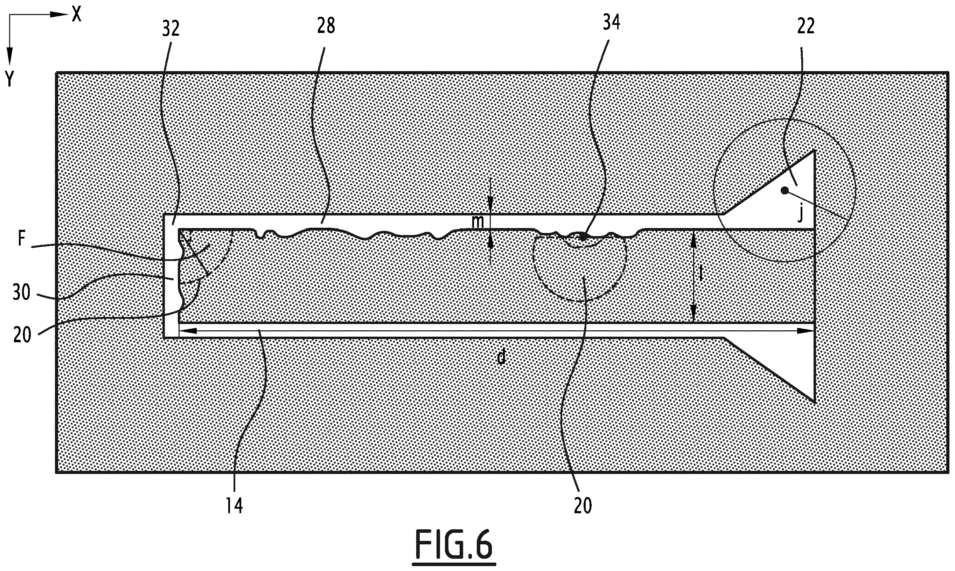

Selon le mode de réalisation illustré par la figure 6, la paroi 14 comporte une paroi de fond 30 et une paroi latérale 28 en liaison avec la paroi du fond 30 au niveau d'une zone de jonction 32.

Le deuxième matériau M2 dans lequel l'espace extérieur 16 est réalisé est un matériau magnétique.

En particulier, le deuxième matériau magnétique M2 forme, selon un mode de réalisation, un système hybride quasi bi-dimensionnel (car le deuxième matériau M2 comporte des épaisseurs de films de quelques plans atomiques qui sont beaucoup plus petites que les autres dimensions du système) comportant une nanostructure composée d'au moins un empilement d'une couche ultra-mince en matériau ferromagnétique et d'une couche d'un métal, non magnétique, à fort SOC. Typiquement, l'épaisseur de la couche à fort SOC est entre 0,2 nanomètres (nm) et 10 nm.

Dans un mode de réalisation, le film ultramince magnétique est remplacé par un empilement de couches comprenant des couches ferro-magnétique(s) (et éventuellement non ferromagnétique(s), comme par exemple Co/Ni/Co/Ni où Co désigne le Cobalt et Ni le nickel, mais la brisure de symétrie à une ou plusieurs des interfaces avec un matériau à fort SOC est préservée.

Par exemple, selon un mode de réalisation, le deuxième matériau M2 est une couche ferromagnétique interfacée avec une couche non magnétique, la couche ferromagnétique comprenant au moins un matériau parmi le fer (Fe), le cobalt (Co) ou le nickel (Ni), une multicouche à aimantation perpendiculaire, une pérovskite ferromagnétique simple ou double à base de Ti, Cr, Mn, Fe, Co, Mo ou Ru, un alliage de type Heusler à base de Fe, Co, Ni ou Mn , un semi-conducteur magnétique, par exemple du GaMnAs, des couches organiques magnétiques ou un alliage magnétique contenant un élément terres rares (Sm, Gd, Tb ou Er par exemple). Pour rappel, un alliage de type Heusler est un alliage métallique ferromagnétique basé sur une phase de Heusler, une phase intermétallique de composition particulière, de structure cristallographique cubique à faces centrées.

Typiquement, l'épaisseur de la ou des couche(s) ferromagnétique(s) est de quelques plans atomiques, et est entre 0,2 nm et 3 nm.

Selon un autre mode de réalisation, le deuxième matériau M2 est une couche non magnétique comprenant au moins un matériau parmi les éléments Pt, W, Ir, Re, Ta, Pb, Bi, Rh, Pd, Mo, Cu, Sm, Gd, Tb ou Er, ladite couche non magnétique étant interfacée avec un couche ferromagnétique ou un empilement de couches ferromagnétique(s) et/ou non magnétique(s). Le platine (Pt), le tungstène (W), l'iridium (Ir), le rhénium (Re), le tantale (Ta), le plomb (Pb), le bismuth (Bi) sont des éléments de la colonne 5d de la classification périodique des éléments ; le rhodium (Rh) et le palladium (Pd) appartiennent à la colonne 4d ; le molybdène (Mo) et le cuivre (Cu) sont des éléments de la colonne 3d et le samarium (Sm), le gadolinium (Gd), le terbium (Tb) ou l'erbium (Er) appartiennent aux terres rares. Il est à noter que des alliages des éléments précédents sont également envisageables, de même que des empilements comme par exemple Bi/Ag (Ag représente l'Argent) ou Au/Ag où Au représente l'or.

Selon un autre mode de réalisation, le deuxième matériau M2 est un matériau magnétique présentant une absence de symétrie d'inversion. Le MnSi, le CoFeGe ou le FeGe sont des exemples de matériaux magnétiques présentant une absence de symétrie d'inversion.

Dans tous les modes de réalisation, le deuxième matériau M2 de l'espace extérieur 16 présente une deuxième longueur d'échange A2. La deuxième longueur d'échange A2 est, par exemple, mesurée par une technique de résonance magnétique.

Le deuxième matériau M2 présente également une deuxième anisotropie magnétique K2. La deuxième anisotropie magnétique K2, à titre d'exemple, est mesurée par une mesure magnétométrique.

Le troisième matériau M3 dans lequel l'espace intérieur est réalisé est un matériau magnétique.

Les mêmes remarques que pour le deuxième magnétique M2 s'appliquent également pour le troisième magnétique M3. Ces remarques ne sont donc pas répétées dans ce qui suit.

Dans tous les modes de réalisation, le troisième matériau M3 de l'espace intérieur 18 présente une troisième longueur d'échange A3 si le troisième matériau M3 est différent du deuxième matériau M2. La troisième longueur d'échange A3 est, par exemple, mesurée par une technique de résonance magnétique.

Le troisième matériau M3 présente également une troisième anisotropie magnétique K3. La troisième anisotropie magnétique K3, à titre d'exemple, est mesurée par une mesure magnétométrique.

Selon l'exemple de la figure 6, la largeur m de la paroi latérale 28, c'est-à-dire la dimension de la paroi latérale 28 le long de la deuxième direction transverse Y, dépend de la nature du premier matériau M1. Lorsque le premier matériau M1 est un matériau magnétique présentant une première longueur d'échange, la largeur m de la paroi latérale 28 est supérieure ou égale à la première longueur d'échange. Lorsque le premier matériau M1 est un matériau conducteur magnétique, la largeur m de la paroi latérale 28 est supérieure ou égale à la longueur de diffusion de spin. Lorsque le premier matériau M1 est isolant ou du vide, la largeur m de la paroi latérale 28 est supérieure ou égale à longueur caractéristique d'effet tunnel (typiquement 1 nm).

Selon un mode de réalisation, le deuxième matériau magnétique M2 et le troisième matériau magnétique M3 sont identiques.

La zone de création 20, aussi appelée zone de nucléation, est propre à générer des demi-bulles.

Les demi-bulles sont aussi appelées par certains auteurs des demi-skyrmions.

La zone de création 20 est dans l'espace intérieur 18.

Selon l'exemple du mode de réalisation illustré par la figure 6, la zone de création 20 est une partie de la zone de jonction 20 dans laquelle l'angle entre la paroi de fond 30 et la paroi latérale 28 est égal à 90°.

Avantageusement, la zone de création 20 est inscriptible dans un cercle dont le rayon F est inférieur ou égal à la troisième longueur d'échange A3 du troisième matériau M3.

Selon le mode de réalisation illustré par la figure 6, la zone de création 20 comprend également un défaut 34 de la paroi 14. Un défaut est une protubérance ou une encoche de taille supérieure ou égale à la troisième longueur d'échange A3 du troisième matériau M3.

La forme des défauts 34 de taille supérieure ou égale à la longueur d'échange A3 est liée notamment à la rugosité des bords de la paroi 14 lors des processus de fabrication. La forme pourra être obtenue par imagerie de microscopie en champ proche ou par microscopie électronique en transmission.

La zone de traitement 21 est propre à effectuer le transfert des demi-bulles que la zone de création 20 est propre à générer vers la sortie 22, ou encore propre à stocker des demi-bulles que la zone de création 20 est propre à générer.

Dans l'exemple particulier de la figure 3, c'est la sortie 22 qui est propre à limiter le contact entre la région 14 et les demi-bulles que la zone de création 20 est propre à générer.

La sortie 22 est en communication avec l'espace extérieur 16.

La sortie 22 est également propre à transformer les demi-bulles en skyrmions.

Selon le mode de réalisation de la figure 4, la sortie 22 présente une forme géométrique dont au moins une dimension est supérieure à l'extension R d'un skyrmion que le système de génération 10 est propre à générer.

Le passage de propagation 24 relie la zone de création 20 à la sortie 22.

Le passage de propagation 24 est propre à faire propager les demi-bulles générées par la zone de création 20 vers la sortie 22.

Le déplacement d'un nombre déterminé de demi-bulles est opéré par effet de transfert de spin, par exemple en géométrie d'injection de courant polarisé en spin, perpendiculairement aux couches ou dans le plan de la couche à fort SOC, ou bien par application d'un champ électrique local.

La polarisation en spin agissant sur la ou les demi-bulles grâce à l'effet de transfert de spin peut être obtenue par les couples de transfert de spin liés à l'effet Hall de spin, par l'effet Rashba (des termes de couple de transfert sont liés directement aux effets spin orbite (SOC) dans le métal non magnétique) ou de manière plus conventionnelle en utilisant une jonction tunnel magnétique. La particularité de ces termes de transfert de spin est qu'ils permettent d'appliquer ces couples pour faire avancer la ou les demi-bulles dans le passage de propagation 24.

Étant donné les avantages énergétiques attendus pour des systèmes de propagation de skyrmions par géométrie d'injection perpendiculaire de spin (J. Sampaio et al. Nature Nanotechnology 8, 839, 2013), le système 10 est intrinsèquement adapté à une intégration dans de tels systèmes.

Pour un passage de propagation 24 de quelques dizaines de nm de largeur, des vitesses de demi-bulles de quelques dizaines de m/s peuvent être obtenues par effet de transfert de spin, correspondant à des densités de courant de quelques MA/cm².

Il est ainsi possible de déplacer des trains de demi-bulles sans modifier notoirement leurs tailles, ni la distance entre deux demi-bulles voisins.

Il est à noter qu'en outre, la forme des demi-bulles et le déplacement des demi-bulles induit par transfert de spin dans le passage de propagation 24 est toujours possible avec une courbure du passage de propagation 24.

Le passage de propagation 24 présente une dimension d le long de la direction longitudinale X appelée longueur et une dimension le long de la deuxième direction transverse Y appelée largeur I.

La longueur d du passage de propagation 24 est supérieure ou égale à l'extension R d'un skyrmion que le système 10 est propre à générer.

La largueur I du passage de propagation 24 est supérieure ou égale à la moitié de l'extension R d'un skyrmion que le système 10 est propre à générer.

Le système de génération 10 comporte également un dispositif de renversement 26 de l'aimantation magnétique propre à renverser l'aimantation magnétique à l'interface entre la région 14 et l'espace intérieur 18.

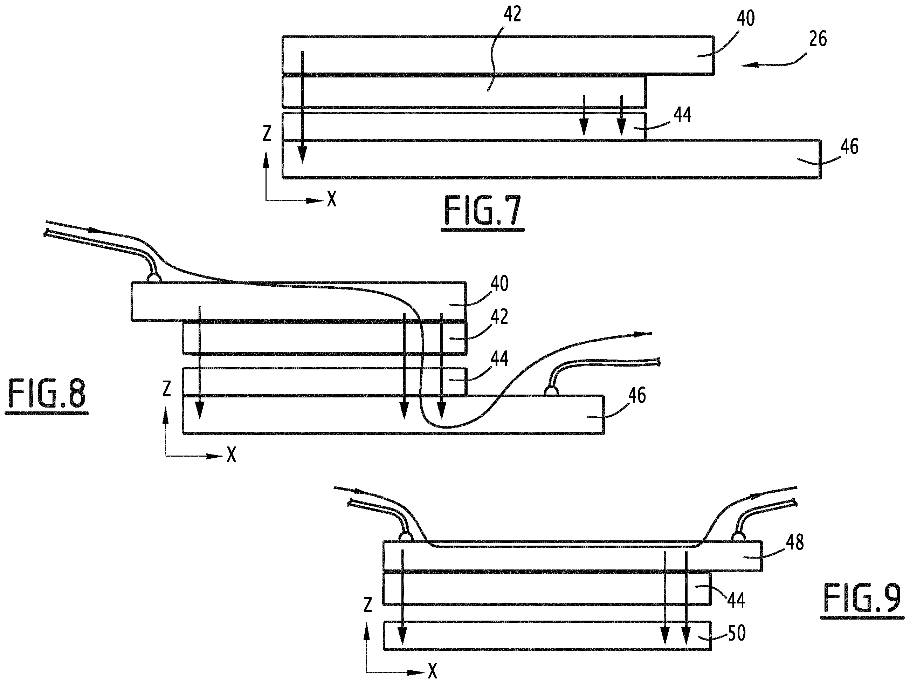

Ainsi que le montre de manière schématique la figure 7, selon un mode de réalisation, le dispositif de renversement 26 est une première unité d'injection de courant dans la première direction transverse Z. La première unité d'injection 26 est propre à injecter à la zone de création 20 un courant polarisé en spin avec une direction de polarisation en spin ayant une composante non nulle le long d'une deuxième direction transverse Y.

Une telle première unité d'injection 26 est, par exemple, un assemblage de trois couches tel que représenté à la figure 7. La figure 7 représente un assemblage de quatre couches 40, 42, 44, 46 alignées le long de la première direction transverse Z, une couche 44 correspondant au système 10 et les autres couches 40, 42, 46 correspondant à la première unité d'injection 26. De haut en bas, la première couche 40 est une électrode supérieure, la deuxième couche 42 est une couche polarisatrice de spin, la troisième couche 44 correspond au système 10 et la quatrième couche 46 est une électrode inférieure.

De préférence, les autres couches 40, 42, 46 correspondant à la première unité d'injection 26 présentent la même géométrie que la couche 44 correspondant au système 10.

Un autre mode de réalisation est représenté à la figure 8, la première couche 40 est un contact électrique supérieur et la quatrième couche 46 est un contact électrique inférieur.

Selon un autre mode de réalisation illustré par la figure 9, au lieu d'un assemblage de trois couches, la première unité d'injection 26 est un assemblage de deux couches 48, 50 entourant la couche 44 correspondant au système 10. Dans une telle configuration, de haut en bas, la première couche 48 est une couche polarisatrice de spin et la deuxième couche 50 est un drain de spin. La premier couche 48 est ainsi une couche polarisatrice de spin, qui n'est pas nécessairement magnétique mais ayant un fort couplage spin orbite permettant de générer un fort courant polarisé en spin par effet Hall de spin.

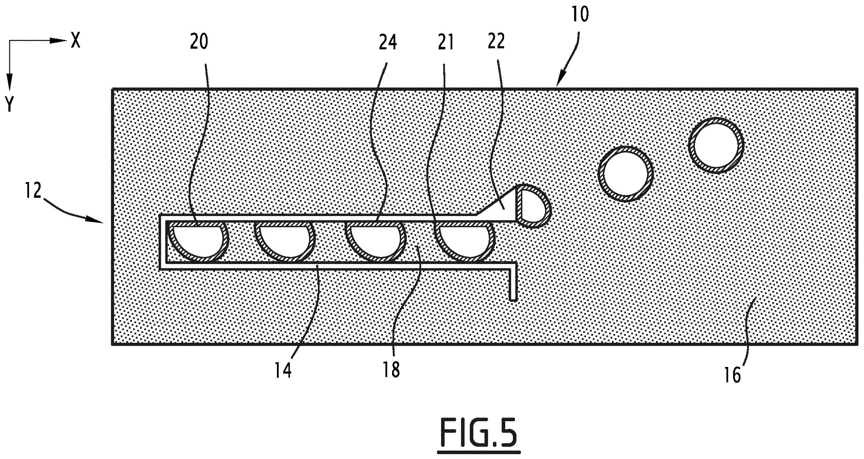

Le fonctionnement du système de génération 10 est maintenant décrit en référence aux figures 4 et 5 qui sont des représentations schématiques d'une vue de haut d'un exemple de système de génération de skyrmions en fonctionnement.

L'injection fonctionne sur la base d'une déstabilisation de l'aimantation dans la zone de création 20. Le degré d'une telle déstabilisation de l'aimantation dans la zone de création 20 est en fait lié à la valeur de l'angle entre la paroi de fond et la paroi latérale. Plus, l'angle entre la paroi de fond et la paroi latérale est fermée, plus l'aimantation dans la zone de création 20 est déstabilisée et favorise le renversement.

En outre, un courant polarisé en spin est injecté en géométrie perpendiculaire.

La composante non nulle le long de la deuxième direction transverse Y de la direction de polarisation en spin du courant polarisé en spin injecté par le dispositif de renversement 26 génère la composante du couple de transfert de spin permettant le renversement de l'aimantation dans la zone de création 20.

La composante non nulle le long de la deuxième direction transverse Y de la direction de polarisation en spin du courant polarisé en spin injecté par le dispositif de renversement 26 permet le déplacement de la demi-bulle une fois créée dans le passage de propagation 24 vers la sortie 22.

L'injection de courant polarisé peut se faire de différentes manières.

Selon un premier mode de réalisation, le courant est injecté avec des variations temporelles.

Par exemple, trois densités de courant différentes sont utilisées. L'injection d'un courant à la première densité de courant induit le renversement de l'aimantation dans la zone de création 20. L'injection d'un courant à la deuxième densité plus faible que la première densité permet la propagation de la demi-bulle formée. L'injection d'un courant à la troisième densité plus forte que la deuxième densité facilite la transformation de la demi-bulle en skyrmion.

Selon un deuxième mode de réalisation, le courant est injecté avec des variations spatiales.

Par exemple, deux densités de courant différentes sont utilisées, une première densité pour la zone de création 20 et une deuxième densité pour le passage de propagation 24.

Selon un troisième mode de réalisation, le courant est injecté avec des variations de la direction de polarisation de spin. Le troisième mode de réalisation est combinable avec le premier mode de réalisation et/ou le deuxième mode de réalisation précédent(s).

La sortie 22 permet enfin le décollement contrôlé des demi-bulles et la formation de skyrmions magnétiques de topologie non-triviale. Etant donné que l'orientation des moments magnétiques dans les parois des demi-bulles (leur chiralité) est fixée par la polarisation en spin du courant injecté et l'aimantation du système, toutes les bulles formées sont des skyrmions ayant un nombre topologique bien déterminé : soit S= 1, ou S= -1 (mais jamais un mélange des deux). Cela assure que tous les skyrmions crées par le système 10 se comportent de manière identique.

La description du fonctionnement du système 10 montre que le système 10 présente de multiples analogies avec les phénomènes de micro-fluidique. A titre d'exemples, dans la suite, sont mises en évidence trois analogies intéressantes.

La première analogie concerne l'énergie de surface des bulles magnétiques. Tout comme pour des bulles fluidiques, l'énergie libre des bulles magnétiques est minimisée pour un rapport maximum de volume sur surface (ou aire sur circonférence). Cela est responsable de la fermeture douce et prévisible de la bulle magnétique lors de sa sortie de la zone de traitement 21, car la relaxation vers une configuration circulaire induit la séparation de la partie arrière de la bulle de la sortie fluidique.

La deuxième analogie se rapporte au phénomène de « mouillage ». A la sortie d'un canal micro-fluidique, l'affinité entre le fluide transporté et l'injecteur peut empêcher le décollement de bulles liquides. Un tel phénomène se retrouve dans la forme d'un ménisque sur les parois d'un verre d'eau. Les simulations indiquent un phénomène analogue dans l'affinité des demi-bulles pour les bords. En effet, c'est pour cette raison que la sortie fluidique présente une forme qui favorise un décollement avec un minimum de « mouillage magnétique ».

La troisième analogie concerne la variante avec la variation temporelle du courant injecté. Tout comme pour un injecteur micro-fluidique, une densité de courant excessive dans la zone de traitement 21 résulte en la formation de longues « plumes » de la phase renversée à la sortie 22 de la zone de traitement 21. En fonction du rapport entre le courant à l'intérieur du zone de traitement 21 et le courant extérieur existant en dehors du canon 12, ces « plumes » peuvent soient gonfler localement à la sortie, soit devenir des longues plumes emportées par le courant extérieur.

Le canon 12 peut ainsi être qualifié de canon « magnéto-fluidique » à skyrmions magnétiques.

Le système 10 permet d'obtenir la stabilisation d'un nombre contrôlé de skyrmions dans une nanostructure. En effet, le système 10 est reproductible, permet le contrôle de la position et de l'instant auquel le skyrmion est créé ainsi que le contrôle de la chiralité du skyrmion.

En effet, le système 10 permet la formation de skyrmions magnétiques de topologie non-triviale, c'est-à-dire de nombre topologique S=1 ou S=-1. Toutes les bulles formées sont des skyrmions ayant un nombre topologique bien déterminé : soit S=1, ou S= -1 mais jamais un mélange des deux.

Reformulée en termes d'opération d'écriture, le système 10 permet d'assurer la reproductibilité, la pureté magnétique (aucune configuration non-désirée n'est produite), la précision spatiale, la précision temporelle et le caractère déterministe (une fois déclenché, l'écriture se fait à un moment bien défini).

Le système 10 permet donc de générer de manière contrôlée des skyrmions.

Une telle génération contrôlée ouvre la voie à une utilisation des skyrmions en nombre contrôlé, notamment pour des mémoires électroniques non volatiles et des mémoires multi-niveaux pour le stockage d'information et de la logique magnétique reprogrammable.

Or, l'utilisation des skyrmions en nombre contrôlé offre de multiples avantages. En particulier, les dimensions des skyrmions (étant définies par des compétitions entre différents termes d'énergie des systèmes considérés et donc contrôlables), peuvent atteindre des limites ultimes de l'ordre de quelques mailles atomiques (inférieures au nanomètre), ce qui permet de répondre à la problématique d'augmentation de la densité d'information stockée.

De plus, la structure interne des skyrmions les rend a priori beaucoup moins sensibles aux défauts structuraux et/ou magnétiques dus par exemple à la nano fabrication, et donc facilite leur déplacement, par effet de transfert de spin, réduisant ainsi le coût énergétique du fonctionnement d'un dispositif à mémoire utilisant des skyrmions.

La génération contrôlée de skyrmions concerne aussi le domaine des circuits bio-inspirés du fait de propriétés memristives.

En outre, les skyrmions magnétiques, tout comme les autres solitons magnétiques, se décrivent comme des particules ou pseudo-particules et donc peuvent être utilisés comme oscillateur ou résonateur pour des systèmes radiofréquence (RF) fortement intégrés. A titre d'exemple, parmi les modes excités de plus basse énergie pour un skyrmion, le mode gyrotropique ou le mode de battement qui ont des fréquences situées dans la gamme du GHz sont des exemples.

Le système 10 présente de plus l'avantage d'être compact car les dimensions du canon 12 sont de l'ordre de la taille des skyrmions générés, c'est-à-dire de quelques nanomètres à quelques dizaines de nanomètres.

En outre, le système 10 est réalisable en utilisant les techniques standards de lithographie électronique et gravure ionique.

De manière générale, une zone de création 20 est une zone favorisant par sa géométrie spécifique la déstabilisation, et par là le renversement local, de spins magnétiques. En effet, la géométrie de la zone de création 20 permet de contrôler les interactions magnétiques jouant un rôle dans la nucléation des skyrmions telles que l'interaction d'échange, l'interaction d'échange asymétrique liée au couplage spin-orbite appelée interaction Dzyaloshinskii- Moriya (DM), ou encore l'interaction dipolaire.

Dans la suite, pour mieux comprendre l'influence de la géométrie de la zone de création 20, l'origine et le rôle de chacune des interactions précitées sont rappelés.

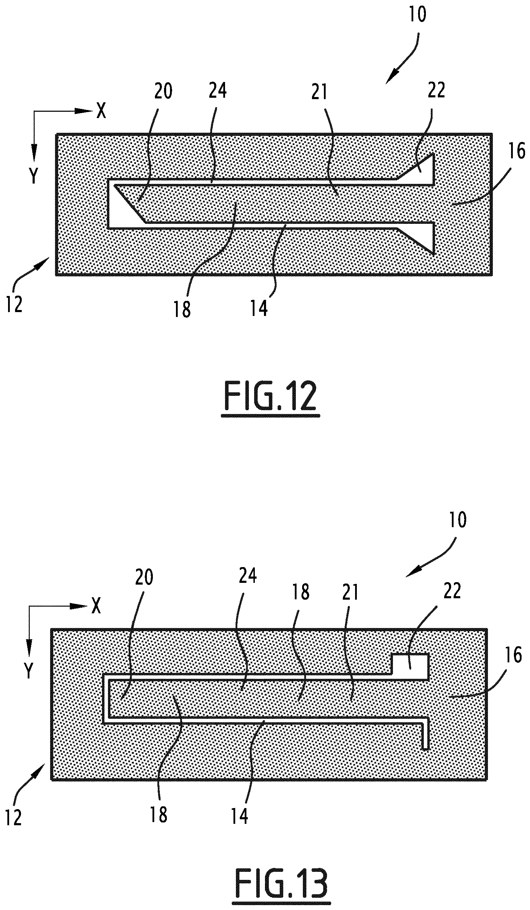

L'interaction d'échange tend à aligner fortement les spins voisins (de manière parallèle dans un ferromagnétique ou de manière antiparallèle dans un antiferromagnétique). Pour renverser localement une aimantation, il convient en général de renverser celle d'une partie de ses atomes voisins. Par conséquent, le renversement de l'aimantation d'un atome ayant peu de voisins requiert une plus faible énergie que celle d'un atome ayant plus de voisins magnétiques. La forme de la zone de création 20 montrée aux figures 12 et 13 minimise le nombre d'atomes autour de certaines régions, notamment les coins de la zone de création 20.

L'interaction dipolaire tend à aligner le pôle 'nord' d'un ensemble d'atomes avec le pôle 'sud' d'un ensemble d'atomes voisins. Une telle interaction fait que les atomes magnétiques de part et d'autre du canon 12 rayonnent un champ dipolaire agissant sur les atomes à l'intérieur du canon 12, tendant à renverser leur aimantation. Les atomes à l'intérieur du canon 12 subissent ainsi une déstabilisation dépendante de la force du champ dipolaire, d'autant plus que leur stabilisation par l'interaction d'échange est fortement diminuée.

Dans le cas où le matériau magnétique est de faible symétrie structurale ou bien un film très mince en contact avec un film de matériau à fort couplage spin-orbite, une troisième interaction est à considérer : l'interaction dite Dzyaloshinskii-Moriya (DM). Cette troisième interaction, équivalente à une interaction d'échange asymétrique, tend à ouvrir l'angle entre des spins voisins. Une conséquence de la présence de l'interaction DM est que les spins en bord de couches magnétiques présentent un décalage angulaire par rapport à l'angle imposé par l'interaction d'échange directe.

La zone de création 20, que cette zone comprenne un coin ou un défaut, fonctionne grâce à la minimisation de l'interaction d'échange locale, la maximisation du champ démagnétisant (dipolaire) local, et en faisant usage d'interactions spin-orbite type DM pour exalter et guider le retournement local d'aimantation.

De ce fait, en variante, l'angle entre la paroi de fond et la paroi latérale est différent de 90°.

En particulier l'angle entre la paroi de fond et la paroi latérale est inférieur ou égal à 180°.

La demanderesse a notamment vérifié par des simulations numériques que l'optimisation de la déstabilisation de l'aimantation dans la zone de création 20 par diminution de l'angle entre la paroi de fond et la paroi latérale peut être faite en réduisant l'angle entre la paroi de fond et la paroi latérale à la condition que les effets de confinement dus au rapprochement des bords ne deviennent pas prépondérants (c'est-à-dire au point de gêner la création de demi-bulles dans l'espace intérieur 18).

La figure 12 illustre une forme de la paroi de fond triangulaire en section favorisant la formation de demi-bulles.

Selon un autre mode de réalisation, le troisième matériau magnétique M3 présente une forme de l'interaction chirale DM propice à stabiliser les skyrmions du type schématisés dans la figure 2. Dans un tel mode de réalisation, la première unité d'injection 26 est propre à injecter à la zone de création 20 un courant polarisé en spin avec une direction de polarisation en spin ayant une composante non nulle le long de la direction X.

En variante, le dispositif de renversement 26 est une unité d'application d'un champ magnétique extérieur à la zone de création 20. Typiquement le champ magnétique que l'unité d'application est propre à appliquer est de quelques dizaines de milliTesla (mT) à quelques centaines de mT.

Selon une autre variante, le dispositif de renversement 26 est une unité de chauffage de la zone de création 20. Par exemple, le dispositif de renversement 26 est une source laser permettant de déstabiliser localement l'aimantation uniquement au niveau de la zone de création 20.

Selon une autre variante, le dispositif de renversement 26 comporte une unité propre à appliquer un champ électrique dans la zone de création 20.

D'autres modes de réalisation pour la zone de traitement 21 des demi-bulles existent pourvu que la zone de traitement 21 soit propre à limiter le contact entre la région 14 et les demi-bulles que la zone de création 20 est propre à générer.

En effet, la formation de skyrmions ayant une chiralité déterminée est fortement influencée par le phénomène de « mouillage magnétique ». La zone de traitement 21 permet de limiter le mouillage magnétique et assure ainsi la formation de skyrmions à la sortie 22 du système 10.

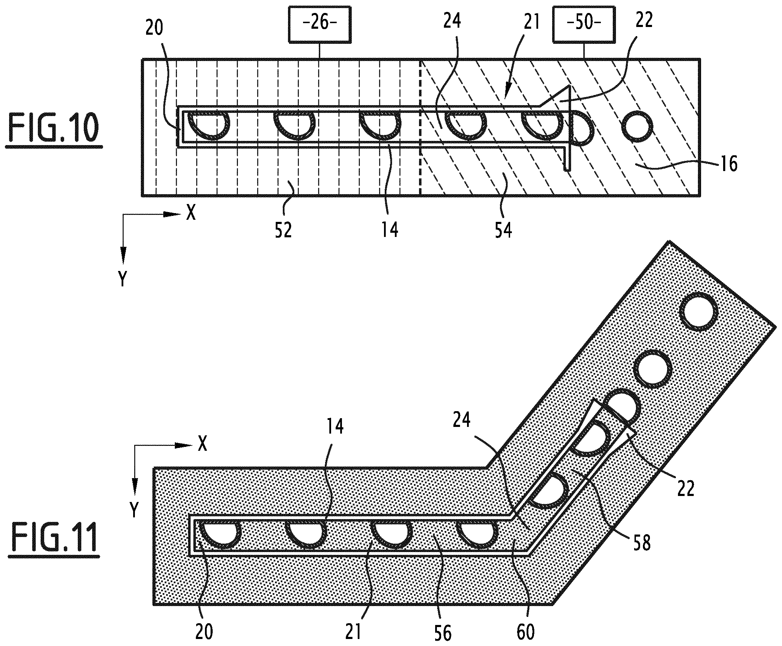

Selon le cas illustré par la figure 10, le dispositif de renversement 26 de l'aimantation magnétique est la première unité d'injection de courant décrite en référence à la figure 5. En outre, le système de génération 10 comporte une deuxième unité d'injection de courant 50 dans la première direction transverse Z. La deuxième unité d'injection de courant 50 est propre à injecter dans le passage de transformation 24 un courant polarisé en spin avec une direction de polarisation en spin différente de la direction de polarisation en spin du courant que la première unité 26 est propre à injecter.

Cela signifie que, selon l'exemple de la figure 10, il existe deux portions 52, 54 différentes dans le passage de propagation 24, la première portion 52 comprenant la zone de création 20 et la deuxième portion 54 comprenant la sortie 22.

Dans la première portion 52, la direction de polarisation du spin permet la création d'une demi-bulle tandis que dans la deuxième portion 54, la direction de la polarisation en spin est choisie pour que la demi-bulle se décolle du canon 12 dans la deuxième portion 54 (réduction du mouillage).

Dans un tel cas, de préférence, la sortie 22 présente une forme plus simple que dans les autres modes de réalisation puisque la sortie 22 n'est plus contrainte à assurer la limitation du contact entre la région 14 et les demi-bulles que la zone de création 20 est propre à générer.

Selon l'exemple de la figure 11, le passage de propagation 24 comporte deux portions 56, 58 reliées par un coude 60.

Selon l'exemple de la figure 11, la première portion 56 et la deuxième portion 58 sont rectilignes.

En outre, la première portion 56 est orientée selon la direction longitudinale X tandis que la direction selon laquelle s'étend la deuxième portion 58 fait un angle avec la direction longitudinale X. En l'occurrence, l'angle entre la direction selon laquelle s'étend la deuxième portion 58 et la direction selon laquelle s'étend la première portion 56 est obtus.

Une telle géométrie du passage de propagation 24 permet à la fois de conserver les conditions optimales pour l'injection dans la zone de création 20 et de permettre l'éjection de la demi-bulle non pas sur un des bras à la sortie du canon 12 mais au centre du canon 12.

Pour cela, le coude présente un angle adapté. L'angle du coude est choisi en fonction de la direction de polarisation du spin du courant injecté par la première unité 26.

Dans un tel cas, la sortie 22 présente une forme plus simple que dans les autres modes de réalisation puisque la sortie 22 n'est plus contrainte à assurer la limitation contact entre la région 14 et les demi-bulles que la zone de création 20 est propre à générer..

En outre, comme le « mouillage magnétique » observé dans les simulations de la demanderesse est en partie une fonction de l'angle entre les bords concernés et la trajectoire de propagation des skyrmions, diverses formes géométriques sont envisageables pour la sortie 22. En particulier, des formes triangulaires, des formes carrées ou des formes arrondies.

Plus précisément, la sortie 22 est formée par deux cylindres dont la base présente une forme variant selon les modes de réalisation.

Dans le cas des figures 4, 6, 11 et 12, chaque cylindre présente une base triangulaire, la sortie 22 étant symétrique.

Selon l'exemple des figures 5 et 10, un des deux cylindres présente une base triangulaire, l'autre présentant une base rectangulaire.

Dans le cas de la figure 13, chaque cylindre présente une base rectangulaire, une des deux bases ayant une section supérieure ou égale à deux fois la section de l'autre base.

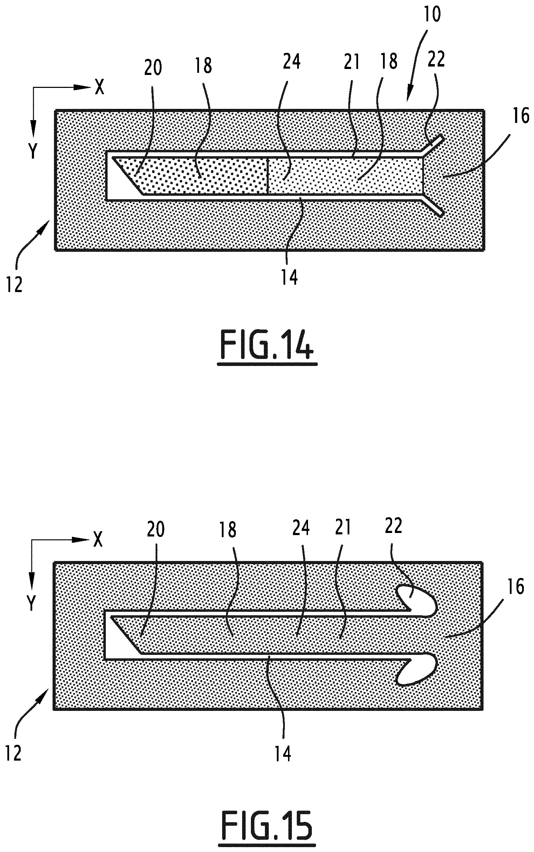

Dans le cas de la figure 14, chaque cylindre présente une même base rectangulaire, les cylindres étant symétriques par rapport à l'axe de symétrie du canon 12.

Dans le cas de la figure 15, chaque cylindre présente une même base ovoïde, les cylindres étant symétriques par rapport à l'axe de symétrie du canon 12.

Dans tous les cas, les dimensions maximales des bases sont de quelques fois la dimension R d'un skyrmion. Typiquement, chaque dimension est inférieure ou égale à trois fois la dimension R d'un skyrmion.

Les modes de fonctionnement et modes de réalisations décrits ci-dessus sont aptes à être combinés les uns aux autres, totalement ou partiellement, pour donner lieu à d'autres modes de réalisation de l'invention.

## Revendications

1. Système (10) de génération de skyrmions comprenant :
- un canon (12) comportant :
- une région formant paroi (14) réalisée en un premier matériau, la région (14) délimitant un espace extérieur (16) réalisé dans un deuxième matériau distinct du premier matériau et un espace intérieur (18) réalisé dans un troisième matériau distinct du premier matériau, le deuxième matériau et le troisième matériau étant des matériaux magnétiques, la région (14) comportant une paroi de fond (30) et une paroi latérale (28) en liaison avec la paroi du fond (30) au niveau d'une zone de jonction (32),
- une zone de création (20) de demi-bulles propre à générer des demi-bulles, la zone de création (20) étant dans l'espace intérieur (18), la zone de création (20) comprenant au moins l'un des deux éléments suivants :
- un ou plusieurs défauts (34) de la paroi (14), et
- une partie de la zone de jonction (32) et
- une zone de traitement (21) des demi-bulles comprenant :
- une sortie (22) en communication avec l'espace extérieur (16), la sortie (22) étant propre à transformer les demi-bulles en skyrmions, et
- un passage de propagation (24) des demi-bulles, le passage (24) reliant la zone de création (20) à la sortie (22),
la zone de traitement (21) étant propre à limiter le contact entre la zone de création (20) et la sortie (22) étant également propre à transformer les demi-bulles en skyrmions, et
- un dispositif de renversement (26) de l'aimantation magnétique propre à renverser l'aimantation magnétique à l'interface entre la région (14) et l'espace intérieur (18), le dispositif de renversement (26) étant choisi dans le groupe constitué de :
- une première unité d'injection de courant dans une première direction transverse, la première unité étant propre à injecter à la zone de création de demi-bulles un courant polarisé en spin avec une direction de polarisation en spin ayant une composante non nulle le long d'une deuxième direction transverse, la première direction transverse et la deuxième direction transverse étant perpendiculaires à une direction longitudinale le long de laquelle s'étend le canon (12),
- une première unité d'injection de courant dans une première direction transverse, la première unité étant propre à injecter à la zone de création de demi-bulles un courant polarisé en spin avec une direction de polarisation en spin ayant une composante non nulle le long d'une direction longitudinale le long de laquelle s'étend le canon (12), la première direction transverse étant perpendiculaire à la direction longitudinale,
- une unité d'application d'un champ magnétique extérieur à la zone de création de demi-bulles,
- une unité de chauffage de la zone de création de demi-bulles, et
- une unité d'application d'un champ électrique extérieur à la zone de création de demi-bulles.

2. Système selon la revendication 1, dans lequel la partie de la zone de jonction (32) est une partie dans laquelle l'angle entre la paroi de fond (30) et la paroi latérale (28) est inférieur ou égal à 180°.

3. Système selon la revendication 1 ou 2, dans lequel au moins l'un du deuxième matériau magnétique et du troisième matériau magnétique est choisi dans le groupe constitué de :
- une couche ferromagnétique interfacée avec une couche non magnétique, la couche ferromagnétique comprenant au moins un matériau parmi Fe, Co ou Ni, un pérovskite ferromagnétique simple ou double base à base de Ti, Cr, Mn, Fe, Co, Mo ou Ru, un alliage Heusler à base de Fe, Co,Ni ou Mn, un semi-conducteur magnétique, une couche organique magnétique ou une couche magnétique contenant des éléments de terres rares.
- une couche non magnétique comprenant au moins un matériau parmi les éléments Pt, W, Ir, Re, Ta, Pb, Bi, Rh, Pd, Mo, Cu, Sm, Gd, Tb ou Er, ladite couche non magnétique étant interfacée avec un couche ferromagnétique ou un empilement de couches ferromagnétique(s) et/ou non magnétique(s), et
- un matériau magnétique présentant une absence de symétrie d'inversion.

4. Système selon la revendication 3, dans lequel le dispositif de renversement (26) de l'aimantation magnétique est la première unité d'injection de courant, le système (10) comportant, en outre, une deuxième unité d'injection de courant dans la première direction transverse, la deuxième unité d'injection de courant étant propre à injecter dans le passage de propagation (24) un courant polarisé en spin avec une direction de polarisation en spin différente de la direction de polarisation en spin du courant que la première unité est propre à injecter.

5. Système selon l'une quelconque des revendications 1 à 4, dans lequel le passage de propagation (24) comporte deux portions reliées par un coude.

6. Système selon l'une quelconque des revendications 1 à 5, dans lequel le système (10) est propre à générer des skyrmions présentant une extension, la sortie présentant une forme géométrique dont au moins une dimension est supérieure à l'extension d'un skyrmion que le système (10) est propre à générer.

7. Système selon l'une quelconque des revendications 1 à 6, dans lequel le système (10) est propre à générer des skyrmions présentant une extension, le passage de propagation (24) présentant une largueur supérieure ou égale à la moitié de l'extension d'un skyrmion que le système (10) est propre à générer.

8. Système selon l'une quelconque des revendications 1 à 7, dans lequel le système (10) est propre à générer des skyrmions présentant une extension, le passage de propagation (24) présentant une longueur supérieure ou égale à l'extension d'un skyrmion que le système (10) est propre à générer.

9. Système selon l'une quelconque des revendications 1 à 8, dans lequel le troisième matériau présente une troisième longueur d'échange, la largeur (m) de la paroi latérale (28) étant supérieure ou égale :
- si le premier matériau est un matériau magnétique présentant une première longueur d'échange, à la première longueur d'échange,
- si le premier matériau est un matériau conducteur magnétique, à la longueur de diffusion de spin, et
- si le premier matériau est isolant ou du vide, à la longueur caractéristique d'effet tunnel.

10. Système selon l'une quelconque des revendications 1 à 9, dans lequel le troisième matériau présente une troisième longueur d'échange, la zone de création (20) étant inscriptible dans un cercle ayant un rayon inférieur ou égal à la troisième longueur d'échange.

## Patentansprüche

1. System (10) zur Erzeugung von Skyrmionen, aufweisend:
- eine Kanone (12), welche aufweist:
- einen eine Wand bildenden Bereich (14), welcher aus einem ersten Material hergestellt ist, wobei der Bereich (14) einen äußeren Raum (16), welcher aus einem zweiten Material, das von dem ersten Material verschieden ist, hergestellt ist, und einen inneren Raum (18), welcher aus einem dritten Material, das von dem ersten Material verschieden ist, hergestellt ist, abgrenzt, wobei das zweite Material und das dritte Material magnetische Materialien sind, wobei der Bereich (14) eine Bodenwand (30) und eine Seitenwand (28), welche auf Niveau einer Verbindungszone (32) mit der Bodenwand (30) in Verbindung steht, aufweist,
- eine Zone zur Erzeugung (20) von Halbblasen, welche dazu in der Lage ist, Halbblasen zu erzeugen, wobei die Zone zur Erzeugung (20) in dem inneren Raum (18) ist, wobei die Zone zur Erzeugung (20) mindestens eines von zwei folgenden Elementen aufweist:
- einen oder mehrere Defekte (34) der Wand (14), und
- einen Teil der Verbindungszone (32), und
- eine Zone zur Behandlung (21) der Halbblasen, welche aufweist:
- einen Ausgang (22), welcher mit dem äußeren Raum (16) in Verbindung steht, wobei der Ausgang (22) dazu geeignet ist, die Halbblasen in Skyrmione umzuwandeln,
- eine Passage zur Propagation (24) der Halbblasen, wobei die Passage (24) die Zone zur Erzeugung (20) mit dem Ausgang (22) verbindet,
wobei die Zone zur Behandlung (21) dazu geeignet ist, den Kontakt zwischen der Zone zur Erzeugung (20) und dem Ausgang (22) zu begrenzen, welcher gleichfalls dazu geeignet ist, die Halbblasen in Skyrmione umzuwandeln,
- eine Vorrichtung zum Umkehren (26) der Magnetisierung, welche dazu geeignet ist, die Magnetisierung an der Schnittstelle zwischen dem Bereich (14) und dem inneren Raum (18) umzukehren, wobei die Vorrichtung zum Umkehren (26) aus der Gruppe ausgewählt ist, welche gebildet ist aus:
- einer ersten Einheit zur Injektion von Strom in eine erste Querrichtung, wobei die erste Einheit dazu geeignet ist, in die Zone zur Erzeugung von Halbblasen einen spinpolarisierten Strom mit einer Spinpolarisationsrichtung, die eine Komponente, welche ungleich Null ist, entlang einer zweiten Querrichtung hat, zu injizieren, wobei die erste Querrichtung und die zweite Querrichtung senkrecht zu einer Längsrichtung, entlang welcher sich die Kanone (12) erstreckt, sind,
- einer ersten Einheit zur Injektion von Strom in eine erste Querrichtung, wobei die erste Einheit dazu geeignet ist, in die Zone zur Erzeugung von Halbblasen einen spinpolarisierten Strom mit einer Spinpolarisationsrichtung, die eine Komponente, welche ungleich Null ist, entlang einer Längsrichtung, entlang welcher sich die Kanone (12) erstreckt, hat, zu injizieren, wobei die erste Querrichtung senkrecht zur Längsrichtung ist,
- einer Einheit zum Anlegen eines äußeren Magnetfelds an die Zone zur Erzeugung von Halbblasen,
- einer Einheit zum Aufheizen der Zone zur Erzeugung von Halbblasen, und
- einer Einheit zum Anlegen eines äußeren elektrischen Felds an die Zone zur Erzeugung von Halbblasen.

2. System gemäß dem Anspruch 1, wobei der Teil der Verbindungszone (32) ein Teil ist, in welchem der Winkel zwischen der Bodenwand (32) und der Seitenwand (28) kleiner oder gleich 180° ist.

3. System gemäß dem Anspruch 1 oder 2, wobei mindestens eines von dem zweiten, magnetischen Material und dem dritten, magnetischen Material aus der Gruppe ausgewählt ist, welche gebildet ist aus:
- einer ferromagnetischen Schicht, welche mit einer nichtmagnetischen Schicht gekoppelt ist, wobei die ferromagnetische Schicht aufweist mindestens ein Material aus Fe, Co oder Ni, ein einfach- oder zweifachbasiertes ferromagnetisches Perowskit auf Basis von Ti, Cr, Mn, Fe, Co, Mo oder Ru, eine heuslersche Legierung auf Basis von Fe, Co, Ni oder Mn, einen magnetischen Halbleiter, eine magnetische, organische Schicht oder eine magnetische Schicht, welche Seltenerdelemente enthält,
- einer nichtmagnetischen Schicht, welche mindestens ein Material aus den Elementen Pt, W, Ir, Re, Ta, Pb, Bi, Rh, Pd, Mo, Cu, Sm, Gd, Tb oder Er aufweist, wobei die nichtmagnetische Schicht mit einer ferromagnetischen Schicht oder einem Stapel aus ferromagnetischen und/oder nichtmagnetischen Schicht(en) verbunden ist, und
- einem magnetischen Material, welches eine Abwesenheit einer Inversionssymmetrie zeigt.

4. System gemäß dem Anspruch 3, wobei die Vorrichtung zum Umkehren (26) der Magnetisierung die erste Einheit zur Injektion von Strom ist, wobei das System (10) ferner eine zweite Einheit zur Injektion von Strom in die erste Querrichtung aufweist, wobei die zweite Einheit zur Injektion von Strom dazu geeignet ist, einen spinpolarisierten Strom mit einer Spinpolarisationsrichtung, welche von der Spinpolarisationsrichtung des Stroms, zu dessen Injektion die erste Einheit geeignet ist, verschieden ist, in die Passage zur Propagation (24) zu injizieren.

5. System gemäß irgendeinem der Ansprüche 1 bis 4, wobei die Passage zur Propagation (24) zwei Abschnitte, welche durch eine Biegung verbunden sind, aufweist.

6. System gemäß irgendeinem der Ansprüche 1 bis 5, wobei das System (10) dazu geeignet ist, Skyrmione, welche eine Ausdehnung aufweisen, zu erzeugen, wobei der Ausgang eine geometrische Form aufweist, von welcher mindestens eine Dimension größer als die Ausdehnung eines Skyrmions ist, zu dessen Erzeugung das System 810) geeignet ist.

7. System gemäß irgendeinem der Ansprüche 1 bis 6, wobei das System (10) dazu geeignet ist, Skyrmione, welche eine Ausdehnung aufweisen, zu erzeugen, wobei die Passage zur Propagation (24) eine Breite aufweist, welche größer oder gleich der Hälfte der Ausdehnung eines Skyrmions ist, zu dessen Erzeugung das System (10) geeignet ist.

8. System gemäß irgendeinem der Ansprüche 1 bis 7, wobei das System (10) dazu geeignet ist, Skyrmione, welche eine Ausdehnung aufweisen, zu erzeugen, wobei die Passage zur Propagation (24) eine Länge aufweist, welche größer oder gleich der Ausdehnung eines Skyrmions ist, zu dessen Erzeugung das System (10) geeignet ist.

9. System gemäß irgendeinem der Ansprüche 1 bis 8, wobei das dritte Material eine dritte Austausch-Länge aufweist, wobei die Breite (m) der Seitenwand (28) größer oder gleich ist:
- falls das erste Material ein magnetisches Material ist, welches eine erste Austausch-Länge aufweist, als die erste Austausch-Länge,
- als die Spindiffusion-Länge, falls das erste Material ein magnetisch leitfähiges Material ist, und
- als die charakteristische Tunneleffekt-Länge, falls das erste Material isolierend oder Vakuum ist.

10. System gemäß irgendeinem der Ansprüche 1 bis 9, wobei das dritte Material eine dritte Austausch-Länge aufweist, wobei die Zone zur Erzeugung (20) in einem Kreis, der einen Radius hat, welcher kleiner oder gleich der dritten Austausch-Länge ist, beschreibbar ist.

## Claims

1. A system (10) to generate skyrmions, comprising:
- a gun (12) having:
- a wall-forming region (14) made of a first material, the region (14) delimiting an outer space (16) made of a second material differing from the first material and an inner space (18) made of a third material differing from the first material, the second material and the third material being magnetic materials, the region (14) comprising a bottom wall (30) and a side wall (28) connected to the bottom wall (30) at a junction zone (32),
- a half-bubble creation zone (20) capable of generating half-bubbles, the creation zone (20) being in the inner space (18), the creation zone (20) comprising at least one of the following two elements:
- one or more defects (34) of the wall (14); and
- part of the junction zone (32); and
- a half-bubble treatment zone (21) comprising:
- an outlet (22) in communication with the outer space (16), the outlet (22) being capable of converting the half-bubbles to skyrmions, and
- a half-bubble propagation passage (24), the passage (24) connecting the creation zone (20) to the outlet (22),
the treatment zone (21) being able to limit the contact between the creation zone (20) and the outlet (22) also being able to convert the half-bubbles to skyrmions; and
- a magnetisation reversal device (26) able to reverse magnetisation at the interface between the region (14) and the inner space (18), the reversal device (26) being selected from the group formed by:
- a first unit to inject current in a first transverse direction, the first unit being capable of injecting a spin-polarised current in the half-bubble creation zone with a spin-polarisation direction having a nonzero component along a second transverse direction, the first transverse direction and the second transverse direction being perpendicular to a longitudinal direction along which the gun (12) extends;
- a first unit to inject current in a first transverse direction, the first unit being capable of injecting a spin-polarised current in the half-bubble creation zone with a spin-polarisation direction having a nonzero component along a longitudinal direction along which the gun (12) extends, the first transverse direction being perpendicular to the longitudinal direction;
- a unit to apply an external magnetic field to the half-bubble creation zone;
- a unit to heat the half-bubble creation zone; and
- a unit to apply an external electrical field to the half-bubble creation zone.

2. The system according to claim 1, wherein the part of the junction zone (32) is a part in which the angle between the bottom wall (30) and the side wall (28) is 180° or less.

3. The system according to claim 1 or 2, wherein at least one of the second magnetic material or third magnetic material is selected from the group formed by:
- a ferromagnetic layer interfaced with a non-magnetic layer, the ferromagnetic layer comprising at least one material from among Fe, Co or Ni, a single or double ferromagnetic perovskite that is Ti, Cr, Mn, Fe, Co, Mo or Ru-based, a Heusler alloy that is Fe, Co, Ni or Mn-based, a magnetic semiconductor, an organic magnetic layer or magnetic layer containing rare earth elements;
- a non-magnetic layer comprising at least one material from among the elements Pt, W, Ir, Re, Ta, Pb, Bi, Rh, Pd, Mo, Cu, Sm, Gd, Tb or Er, said non-magnetic layer being interfaced with a ferromagnetic layer or a stack of ferromagnetic and/or non-magnetic layers; and
- a magnetic material lacking inversion symmetry.

4. The system according to claim 3, wherein the magnetisation reversal device (26) is the first current injection unit, the system (10) additionally comprising a second current injection unit in the first transverse direction, the second current injection unit being capable of injecting a spin-polarised current in the propagation passage (24) with a spin-polarisation direction differing from the spin-polarisation direction of the current that the first unit is able to inject.

5. The system according to any of claims 1 to 4, wherein the propagation passage (24) comprises two portions connected by an elbow.

6. The system according to any of claims 1 to 5, wherein the system (10) is capable of generating skyrmions having an extension, the outlet having a geometric shape of which at least one dimension is greater than the extension of a skyrmion able to be generated by the system (10).

7. The system according to any of claims 1 to 6, wherein the system (10) is capable of generating skyrmions having an extension, the propagation passage (24) having a width equal to or greater than one half of the extension of a skyrmion able to be generated by the system (10).

8. The system according to any of claims 1 to 7, wherein the system (10) is capable of generating skyrmions having an extension, the propagation passage (24) having a length equal to greater than the extension of a skyrmion able to be generated by the system (10).

9. The system according to any of claims 1 to 8, wherein the third material has a third exchange length, the width (m) of the side wall (28) being equal to or greater than:
- the first exchange length, if the first material is a magnetic material having a first exchange length;
- the spin-diffusion length, if the first material is a magnetic conducting material; and
- the characteristic tunnel effect length, if the first material is insulating or a vacuum.

10. The system according to any of claims 1 to 9, wherein the third material has a third exchange length, the creation zone (20) being inscribable in a circle having a radius equal to or smaller than the third exchange length.
